# EUROPEAN PATENT SPECIFICATION

(11) **EP 4 468 477 B1**
(45) Date of publication and mention of the grant of the patent: **15.07.2026**
(21) Application number: 23745856.7
(22) Date of filing: 06.01.2023
(51) Int. Cl.: H01M 50/209, H05K 1/02, H05K 1/18, H01M 50/519, H01M 10/42, H01M 50/507, H01M 50/509, H01M 50/569, H01M 50/204, H01M 10/48, H05K 1/189

(54) **FLEXIBLE CIRCUIT BOARD ASSEMBLY, BATTERY AND ELECTRIC DEVICE**
FLEXIBLE LEITERPLATTENANORDNUNG, BATTERIE UND ELEKTRISCHE VORRICHTUNG
ENSEMBLE CARTE DE CIRCUIT IMPRIMÉ FLEXIBLE, BATTERIE ET DISPOSITIF ÉLECTRIQUE

(30) Priority: 27.01.2022 CN 202220231816 U
(43) Date of publication of application: 27.11.2024
(73) Proprietor: Contemporary Amperex Technology (Hong Kong) Limited, Hong Kong (HK)
(72) Inventor: GAO, Yu, Ningde City, Fujian 352100 (CN); WANG, Chong, Ningde City, Fujian 352100 (CN); ZHENG, Chenling, Ningde City, Fujian 352100 (CN)
(74) Representative: Gong, Jinping
(86) International application number: PCT/CN2023/071029
(87) International publication number: WO 2023/142971

(56) References cited:
- EP-A1- 3 923 408
- CN-A- 108 155 506
- CN-A- 112 310 567
- CN-U- 209 860 056
- CN-U- 214 477 805
- CN-U- 215 644 845
- CN-U- 216 903 165
- US-A1- 2019 181 418
- US-A1- 2020 350 636

## Description

### Cross-reference to Related Applications

The present disclosure claims the priority to the Chinese patent application with the filling No. 202220231816.5 filed on January 27, 2022, and entitled "Flexible Circuit Board Component, Battery, and Electric Device".

### Technical Field

The present disclosure relates to the technical field of batteries, in particular to a flexible circuit board component, a battery, and an electric device.

### Background Art

Batteries have extensive applications in the field of new energy, such as electric vehicles and new energy vehicles. New energy vehicles and electric vehicles have become a new trend in the development of the automotive industry. For the convenient management of batteries, it is necessary to collect the voltage and temperature of each battery cell within the battery. In existing technology, flexible circuit boards are commonly used to connect to each battery cell, thereby enabling the collection of voltage and temperature from the battery cell. However, after a period of use of the battery, the flexible circuit board may detach from the battery cells, resulting in the inability to collect voltage and temperature from the battery cells.

EP 3 923 408 A1 describes a connecting assembly including a plurality of connecting sheets, a sampling assembly, and an insulating film. The plurality of connecting sheets are configured to connect battery cells of the battery module. The sampling assembly includes a circuit board and a sampling terminal connected to the circuit board. The sampling terminal is connected to the plurality of connecting sheets. The insulating film is provided at one side of the sampling assembly and the plurality of connecting sheets, and connects the sampling assembly to the plurality of connecting sheets to form an integral structure with the sampling assembly and the plurality of connecting sheets. An insulating film through hole is provided in a region of the sampling assembly covered by the insulating film.

US 2020/350636 A1 describes a battery module including a battery assembly, including a plurality of battery cells arranged in an array, wherein each of the battery cells includes a vent; a circuit board, including a plurality of sampling terminals connected to the battery cells and being capable of collecting electrical parameters and/or temperature parameters of the battery cells; and a thermal cable, located between the battery assembly and the circuit board and fixedly coupled to the circuit board, wherein a thermal circuit is formed inside the thermal cable, and the thermal circuit can provide a prompt signal indicating a bursting of the vent of any of the battery cells.

### Summary

The invention is defined by the appended claims. The described embodiments of the present disclosure are not to be regarded as necessarily defining the invention unless they fall within the scope of the appended claims. Embodiments not falling within the terms of the claims are to be understood as background art or examples useful for understanding the invention.

The objective of the embodiments of the present disclosure is to provide a flexible circuit board component, a battery, and an electric device. It aims to address the issue in the related technology where the flexible circuit board tends to detach from the battery cell after a period of use of the battery.

In the first aspect, the embodiments of the present disclosure provide a flexible circuit board component. The flexible circuit board component comprises a board body and a sampling terminal, wherein the sampling terminal is configured to collect the electrical data of the target component. The board body is provided thereon with a groove portion, wherein the groove portion penetrates the board body along a thickness direction of the board body so as to partition the board body into a main body part, a connecting part, and a deformable part. The connecting part is configured to connect the sampling terminal, and the deformable part is connected to the main body part and the connecting part. The deformable part is configured to undergo deformation so as to allow the connecting part to displace relative to the main body part.

In the above technical solution, the flexible circuit board component is provided with a groove portion penetrating the board body along the thickness direction of the board body, and thus, the deformable part and the connecting part are formed on the board body, wherein the connecting part is connected to the sampling terminal. When external force is applied to the sampling terminal, the deformable part can undergo deformation, thus allowing the sampling terminal to move relative to the main body part. This prevents damage to the sampling terminal or the board body when the sampling terminal is subjected to external force and cannot move relative to the board body. After a certain period of the use of the battery, the battery cell may experience expansion and displacement, exerting external force on the sampling terminals. In the flexible circuit board component provided by the embodiments of the present disclosure, the sampling terminal can move along with the expansion of the battery cells. Therefore, this prevents the separation of the flexible circuit board component from the battery cell so as to allow continuous collection of voltage and temperature from the battery cell. The main body part, connecting part, and deformable part of the flexible circuit board component can be formed in a single step through the stamping of the board body. This manufacturing process is simple, convenient, and efficient.

As an optional technical solution in the embodiments of the present disclosure, the board body is provided with an edge. The groove portion comprises a first groove and a second groove. The first groove includes a first groove segment, a second groove segment, and a third groove segment which are sequentially connected. One end of the first groove segment penetrates through the edge, and the second groove segment extends along an extension direction of the edge. The first groove segment and the third groove segment are on the same side of the second groove segment. One end of the second groove penetrates through the edge, and the deformable part is formed in a region of the board body between the second groove and the third groove segment.

In the above technical solution, by arranging the first groove segment and the second groove segment on the board body, the board body is partitioned into a main body part and a connecting part. The third groove segment and the second groove, provided on the board body, weaken the strength of the portion between the connecting part and the main body part, thus making it easy to deform so that a deformable part is partitioned between the main body part and the connecting part. In this way, when external force is applied to the sampling terminal, the external force is transmitted to the connecting part, and the connecting part pulls the deformable part so as to cause the deformable part to undergo deformation. Therefore, it allows the sampling terminal to move relative to the main body part. This prevents damage to the sampling terminal or the board body when the sampling terminal is subjected to external force and cannot move relative to the board body.

As an optional technical solution in the embodiments of the present disclosure, the second groove extends from the edge toward a direction close to the second groove segment, and the third groove segment extends from the second groove segment toward a direction close to the edge. In the extension direction of the edge, the second groove is arranged between the third groove segment and the first groove segment.

In the above technical solution, the second groove extends from the edge towards the second groove segment. In comparison to the third groove segment, the second groove is closer to the connecting part. When welding the sampling terminal to the connecting part, the second groove can reduce the transfer of heat to the main body part, thereby minimizing the impact of heat on the main body part during welding.

As an optional technical solution in the embodiments of the present disclosure, the second groove includes a fourth groove segment and a fifth groove segment which are sequentially connected. One end of the fourth groove segment penetrates through the edge, and the fifth groove segment is arranged in a mutually coiled manner with the third groove segment to make the deformable part extend along a spiral trajectory.

In the above technical solution, by mutually coiling the third groove segment and the fifth groove segment, the deformable part extends along a spiral trajectory. The deformable part extending along the spiral trajectory is more prone to deformation, and the deformation range is relatively large.

As an optional technical solution in the embodiments of the present disclosure, the amount of deformation of the deformable part allows the connecting part to be displaced beyond the first groove segment in an extension direction along the edge.

In the above technical solution, by the amount of deformation of the deformable part, the connecting part is allowed to displace beyond the first groove segment in the extension direction of the edge. Therefore, a sufficient relative displacement is provided for the connecting part relative to the main body part, so as to adapt the amount of the expansion displacement of the battery cell.

As an optional technical solution in the embodiments of the present disclosure, the board body includes a weak part, and the weak part is connected to the opposite two groove walls of the first groove segment.

In the above technical solution, by using the weak part, the opposite two groove walls of the first groove segment are connected so as to facilitate the positioning of the connecting part and the sampling terminal during assembly, thereby improving the accuracy of the connection between the connecting part and the sampling terminal.

As an optional technical solution in the embodiments of the present disclosure, the deformable part includes a first winding segment and a second winding segment. One end of the first winding segment is connected to one end of the second winding segment. The first winding segment and the second winding segment wind in the same direction with their connection position as the winding center. The other end of the first winding segment is connected to the connecting part, and the other end of the second winding segment is connected to the main body part.

In the above technical solution, the deformable part forms a winding structure by making the first winding segment and the second winding segment wind in the same direction. The winding structure is more prone to deformation, and the deformation range is relatively large, thereby allowing it to adapt the amount of the expansion displacement of the battery cell.

As an optional technical solution in the embodiments of the present disclosure, the deformable part extends along an S-shaped trajectory.

In the above technical solution, the deformable part that extends along an S-shaped trajectory is more prone to deformation and maintains good strength.

According to the invention, the deformable part extends along a spiral trajectory.

In the above technical solution, the deformable part extending along the spiral trajectory is more prone to deformation, and the deformation range is relatively large.

In the second aspect, the embodiments of the present disclosure also provide a battery. The battery includes multiple battery cells, a busbar component, and the aforementioned flexible circuit board component. The busbar component is configured to connect the multiple battery cells in series or in parallel, and the sampling terminal is connected to the busbar component.

In the third aspect, the embodiments of the present disclosure further provide an electric device, wherein the electric device includes the battery as described above, wherein the battery is configured to provide electrical energy.

### Brief Description of Drawings

To more clearly illustrate the technical solutions of the embodiments of the present disclosure, the following will briefly introduce the drawings used in the embodiments. It should be understood that the following drawings only show some embodiments of the present disclosure, and therefore they should not be regarded as a limitation on the scope. Those ordinary skilled in the art can also obtain other related drawings based on these drawings without inventive effort.
FIG. 1 is a schematic diagram of the structure of a vehicle provided in some embodiments of the present disclosure;
FIG. 2 is an exploded view of a battery provided in some embodiments of the present disclosure;
FIG. 3 is a schematic diagram of a connection between a flexible circuit board component and a busbar component provided by some embodiments of the present disclosure;
FIG. 4 is a schematic diagram of the structure of a flexible circuit board component provided by some embodiments not falling within the terms of the claims;
FIG. 5 is an enlarged view at part A in FIG. 4; and
FIG. 6 is a schematic diagram of the structure of the flexible circuit board component provided by some embodiments of the present disclosure.

Reference numerals: 100- battery; 10- box; 11- first portion; 12- second portion; 20- battery cell; 30- flexible circuit board component; 31- board body; 311- main body part; 312- deformable part; 3121- first winding segment; 3122- second winding segment; 313- connecting part; 32-sampling terminal; 33- groove portion; 331- first groove; 3311- first groove segment; 3312- second groove segment; 3313- third groove segment; 332- second groove; 3321- fourth groove segment; 3322- fifth groove segment; 34- edge; 35- weak part; 40- busbar component; 200- controller; 300-motor; 1000- vehicle.

### Detailed Description of Embodiments

The following will provide a detailed description of the embodiments of the technical solution of the present disclosure, in conjunction with the accompanying drawings. The following examples are provided solely for a clearer illustration of the technical solutions in the present disclosure. They are presented as examples and should not be used to limit the scope of protection of the present disclosure.

Unless otherwise defined, all technical and scientific terms used herein have the same meaning as understood by those skilled in the art of the relevant technical field. The terms used herein are used for the purpose of describing specific embodiments and are not intended to limit the present disclosure. The terms "comprise" and "provide" and their variations, as well as any other variations, are intended to cover non-exclusive inclusion in the summary and the claims of the present disclosure, as well as in the drawings.

In the description of the embodiments of the present disclosure, the technical terms "first", "second", etc. are used solely for the purpose of distinguishing different objects and should not be construed as indicating or implying relative importance or suggesting a specific quantity, specific order, or hierarchical relationship of the indicated technical features. In the description of the embodiments of the present disclosure, "plurality" means at least two, such as two, three, etc., unless otherwise expressly and specifically limited.

The term "embodiment" used herein means that specific features, structures, or characteristics described in conjunction with the embodiment can be included in at least one embodiment of the present disclosure. The use of this phrase in various parts of the summary does not necessarily refer to the same embodiment, nor does it imply that these embodiments are mutually exclusive or independent of each other. Those skilled in the art understand explicitly and implicitly that the embodiments described herein can be combined with other embodiments.

In the embodiments of the present disclosure, the term "and/or" is used as a way to describe the relationship between associated objects, indicating that there can be three possible relationships. For example, "A and/or B" can represent: the presence of A alone, the presence of both A and B, or the presence of B alone. Additionally, the character "/" in the present disclosure generally represents an "or" relationship between the preceding and following associated objects.

In the embodiments of the present disclosure, the term "multiple" refers to two or more (including two). Similarly, "multiple groups" refers to two or more groups (including two groups), and "multiple pieces" refers to two or more pieces (including two pieces).

Additionally, in the description of the embodiments of the present disclosure, technical terms such as "center", "longitudinal", "lateral", "length", "width", "thickness", "up", "down", "front", "back", "left", "right", "vertical", "horizontal", "top", "bottom", "inner", "outer", "clockwise", "counterclockwise", "axial", "radial", "circumferential", etc., indicating orientations or positional relationships, are based on the orientations or positional relationships shown in the drawings. These terms are used merely for the purpose of facilitating the description of the embodiments of the present disclosure and simplifying the description, and should not be construed as indicating or implying that the devices or components referred to must have specific orientations or be constructed and operated in specific orientations. Therefore, they should not be understood as limiting the embodiments of the present disclosure.

In the description of the embodiments of the present disclosure, unless otherwise expressly specified and limited, technical terms such as "provide", "connect", "link", "fix", and similar terms should be broadly interpreted. For example, they can refer to fixed connections, detachable connections, or integral connections. They can also involve mechanical connections or electrical connections. Connections can be direct or indirect through intermediate media. Furthermore, the terms may refer to internal connections within two components or the interaction between two components. Those of ordinary skill in the art can understand the meanings of the above terms in the embodiments of the present disclosure according to specific situations.

Currently, looking at the development of market trends, the application of batteries is becoming increasingly widespread. Batteries are not only applied in energy storage systems such as hydro power, thermal power, wind power, and solar power stations but are also extensively used in electric transportation such as electric bicycles, electric motorcycles, electric cars; military equipment, aerospace, and many other fields. As the application areas of batteries continue to expand, the demand for batteries in the market is also constantly increasing.

For the convenient management of batteries, it is necessary to collect the voltage and temperature of each battery cell within the battery. In existing technology, flexible circuit boards are commonly used to connect to each battery cell, thereby facilitating the collection of voltage and temperature from the battery cell. However, after a period of use, the flexible circuit board may detach from the battery cells, resulting in the inability to collect voltage and temperature from the battery cells.

The inventors have found that the chemical reaction of the battery cell during charging and discharging causes the volume of the battery cell to change, resulting in relative stresses in the connection portion of the flexible circuit board and the battery cell. With the increase in battery usage time, the individual battery cell may undergo significant expansion displacement. When the expansion reaches a certain level, the sampling connection points of the flexible circuit board may experience tearing, detachment, or other failure conditions, thus leading to the inability to collect voltage and temperature from the battery cell.

Based on the considerations mentioned above, the inventors conducted in-depth research and designed a flexible circuit board component. The flexible circuit board component is provided with a groove portion penetrating the board body along the thickness direction of the board body, and thus, the deformable part and the connecting part are formed on the board body, wherein the connecting part is connected to the sampling terminal. When external force is applied to the sampling terminal, the deformable part can undergo deformation, thus allowing the sampling terminal to move relative to the main body part. This prevents damage to the sampling terminal or the board body when the sampling terminal is subjected to external force and cannot move relative to the board body.

After a certain period of the use of the battery, the battery cell may experience expansion and displacement, exerting external force on the sampling terminals. **In** the flexible circuit board component provided by the embodiments of the present disclosure, the sampling terminal can move along with the expansion of the battery cells. Therefore, this prevents the separation of the flexible circuit board component from the battery cell so as to allow continuous collection of voltage and temperature from the battery cell.

The main body part, connecting part, and deformable part of the flexible circuit board component can be formed in a single step through the stamping of the board body. This manufacturing process is simple, convenient, and efficient.

The flexible circuit board component disclosed in the embodiments of the present disclosure can be a secondary battery or a primary battery; it can also be a lithium-sulfur battery, sodium-ion battery, magnesium-ion battery, or other types, but is not limited to these. A power system of an electric device can be formed using a battery comprising the flexible circuit board disclosed in the present disclosure. Therefore, it is advantageous for enhancing the stability of battery performance and extending battery life.

The embodiments of the present disclosure provide an electric device that uses batteries as a power source. The electric device can comprise but is not limited to, mobile phones, tablets, laptops, electric toys, power tools, electric bicycles, electric cars, boats, spacecraft, and more. The electric toys can include stationary or mobile electric toys, for example, video game consoles, electric car toys, electric boat toys, and electric airplane toys. The spacecraft can include aircraft, rockets, space shuttles, and spacecraft, among others.

For ease of explanation, the following embodiment will be described using one embodiment of the present disclosure where the electric device is a vehicle 1000 as an example.

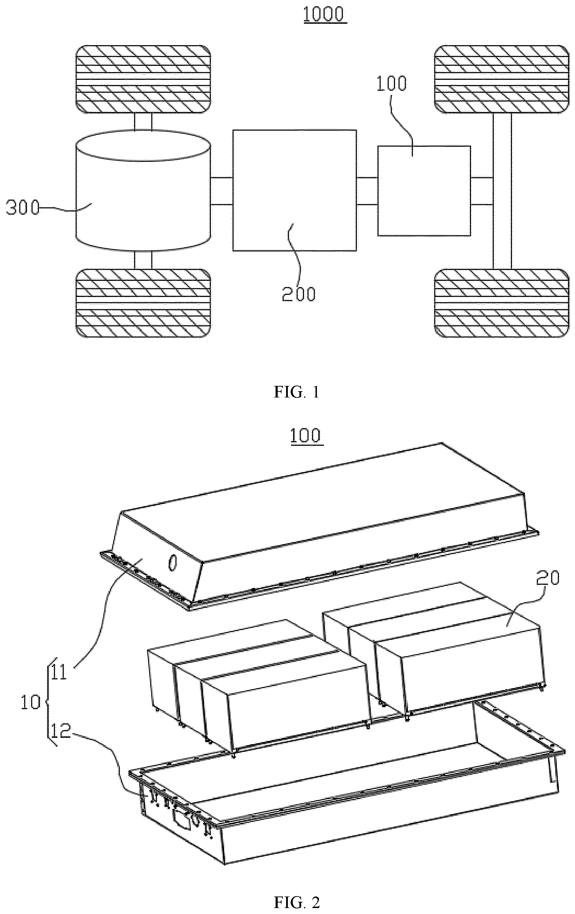

Referring to FIG. 1, FIG. 1 is a schematic diagram of the structure of a vehicle 1000 provided in some embodiments of the present disclosure.

The vehicle 1000 can be a gasoline-powered car, a natural gas car, or a new energy vehicle. The new energy vehicles can be pure electric cars, hybrid cars, extended-range cars, etc. A battery 100 is provided inside the vehicle 1000, wherein the battery 100 can be arranged at the bottom, front, or rear of the vehicle 1000. The battery 100 is configured to provide power for the vehicle 1000. For instance, the battery 100 can serve as the operational power source for the vehicle 1000. Additionally, the vehicle 1000 also comprises a controller 200 and a motor 300. The controller 200 is configured to manage the supply of power from the battery 100 to the motor 300, e.g., for working power requirements for starting, navigating, and driving the vehicle 1000.

In some embodiments of the present disclosure, the battery 100 serves not only as the operational power source for the vehicle 1000 but also as the driving power source for the vehicle 1000. It can replace or partially substitute for conventional fuels like gasoline or natural gas to provide driving propulsion for the vehicle 1000.

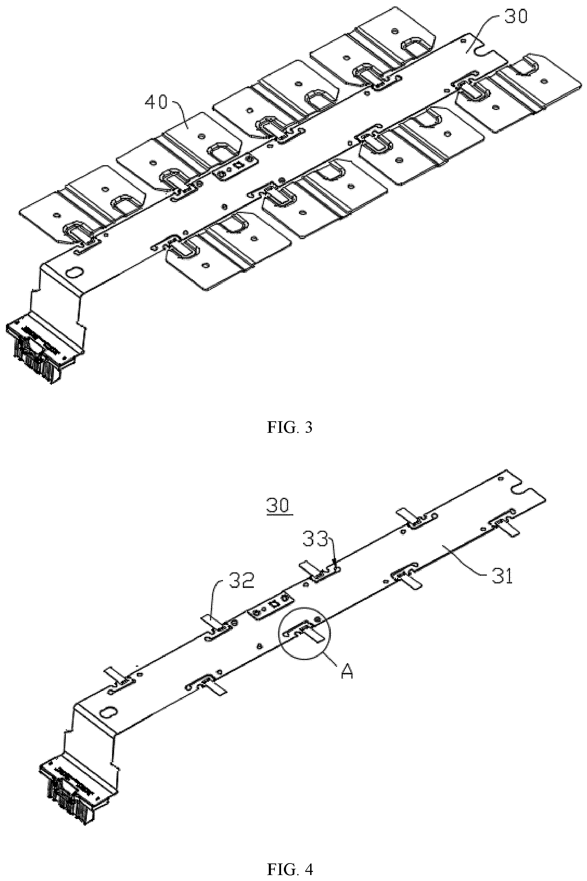

Referring to FIG. 2 and FIG. 3, FIG. 2 is an exploded view of a battery 100 provided in some embodiments of the present disclosure, and FIG. 3 is a schematic diagram of a connection between a flexible circuit board component 30 and a busbar component 40 provided by some embodiments of the present disclosure. The battery 100 comprises a box 10, a battery cell 20, a flexible circuit board component 30, and a busbar component 40, wherein the box 20 is housed the battery cell 10. The box 10 is configured to provide a containment space for the battery cell 20, and the box 10 can be of various structures. In some embodiments, the box 10 can comprise a first portion 11 and a second portion 12, wherein the first portion 11 and the second portion 12 are fitted together. The first portion 11 and the second portion 12 together define the containment space used to accommodate the battery cell 20. The second portion 12 can be a hollow structure open at one end, and the first portion 11 can be a plate-like structure. The first portion 11 is capped over an opening side of the second portion 12 so that the first portion 11 and the second portion 12 together define a containment space. Additionally, both the first portion 11 and the second portion 12 can be hollow structures open at one end, and an open side of the first portion 11 is capped over an opening side of the second portion 12. Of course, the box 10 formed by the first portion 11 and the second portion 12 can be of a variety of shapes, e.g., cylindrical, rectangular, etc.

The battery cell 20 refers to the smallest unit comprising the battery 100. In the battery 100, multiple battery cells 20 can be provided. The multiple battery cells 20 can be connected in series, parallel, or hybrid. Hybrid connection refers to having both series and parallel connections among multiple battery cells 20. The multiple battery cells 20 can be directly connected in series, parallel, or a combination thereof, and then the whole comprising the multiple battery cells 20 is housed in the box 10. Of course, the battery 100 can also be in the form that the multiple battery cells 20 are first connected in series, parallel, or hybrid to form battery modules, and then the multiple battery modules are connected in series, parallel, or hybrid to be formed as a whole, which is housed in the box 10.

Each battery cell 20 can be a secondary battery cell or a primary battery cell. It can also be a lithium-sulfur battery cell, sodium-ion battery cell, magnesium-ion battery cell, or other types, but is not limited to these. The battery cell 20 can have various shapes such as cylindrical, flat, rectangular, or other shapes.

The flexible circuit board component 30 is a component connected to the battery cell 20 and it collects electrical data such as voltage and temperature from the battery cell 20. The busbar component 40 is configured for achieving an electrical connection between the multiple battery cells 20. According to some embodiments of the present disclosure, the flexible circuit board component 30 is electrically connected to the busbar component 40, and the busbar component 40 is electrically connected to the battery cell 20. In other words, the flexible circuit board component 30 is electrically connected to the battery cell 20 through the busbar component 40, or the busbar component 40 is electrically connected to both the flexible circuit board component 30 and the battery cell 20.

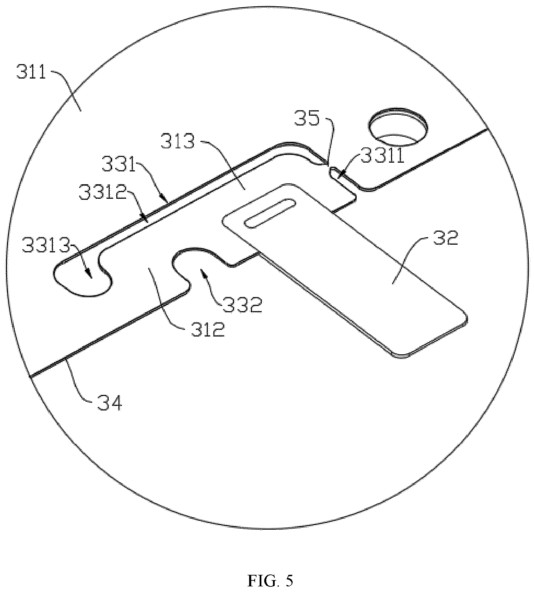

Referring to FIG. 4, in conjunction with reference to FIG. 5, FIG. 4 is a schematic diagram of the structure of a flexible circuit board component 30 provided by some embodiments of the present disclosure; and FIG. 5 is an enlarged view at part A in FIG. 4. According to some embodiments of the present disclosure, a flexible circuit board component 30 is provided. The flexible circuit board component 30 comprises a board body 31 and a sampling terminal 32, wherein the sampling terminal 32 is configured to collect the electrical data of the target component. The board body 31 is provided thereon with a groove portion 33, wherein the groove portion 33 penetrates the board body 31 along a thickness direction of the board body 31 so as to partition the board body 31 into a main body part 311, a connecting part 313, and a deformable part 312. The connecting part 313 is configured to connect the sampling terminal 32, and the deformable part 312 is connected to the main body part 311 and the connecting part 313. The deformable part 312 is configured to undergo deformation so as to allow the connecting part 313 to displace relative to the main body part 311.

The board body 31 is the main part of the flexible circuit board component 30, and it can perform operations such as transferring, gathering, and/or processing the electrical data collected by the sampling terminal 32.

The sampling terminal 32 is the component within the flexible circuit board component 30 configured for collecting electrical data from the target component. The electrical data includes but is not limited to data such as the temperature, voltage, or current of the target component.

The groove portion 33 is a groove that penetrates the board body 31 along the thickness direction of the board body 31.

The main body part 311 is the main structural part of the board body 31, the connecting part 313 is the part on the board body 31 configured to connect the sampling terminal 32, and the deformable part 312 is the part on the board body 31 arranged between the main body part 311 and the connecting part 313. The deformable part 312 can undergo deformation so as to allow the connecting part 313 to displace relative to the main body part 311. Both the deformable part 312 and the connecting part 313 are electrically connected to the main body part 311 so as to allow the sampling terminal 32 to transfer the collected electrical data to the main body part 311 when electrically connected to the connecting part 313.

The flexible circuit board component 30 is provided with a groove portion 33 penetrating the board body 31 along the thickness direction of the board body 31, and thus, the deformable part 312 and the connecting part 313 are formed on the board body 31, wherein the connecting part 313 is connected to the sampling terminal 32. When external force is applied to the sampling terminal 32, the deformable part 312 can undergo deformation, thus allowing the sampling terminal 32 to move relative to the main body part 311. This prevents damage to the sampling terminal 32 or the board body 31 when the sampling terminal 32 is subjected to external force and cannot move relative to the board body 31.

After a certain period of the use of the battery 100, the battery cell 20 may experience expansion and displacement, exerting external force on the sampling terminals 32. In the flexible circuit board component 30 provided by the embodiments of the present disclosure, the sampling terminal 32 can move along with the expansion of the battery cells 20. Therefore, this prevents the separation of the flexible circuit board component 30 from the battery cell 20 so as to allow continuous collection of voltage and temperature data from the battery cell 20.

The main body part 311, connecting part 313, and deformable part 312 of the flexible circuit board component 30 can be formed in a single step through the stamping of the board body 31. This manufacturing process is simple, convenient, and efficient.

According to some embodiments of the present disclosure, the connecting part 313 is provided with a bonding pad, and the deformable part 312 is provided therein with a wire. The wire electrically connects the bonding pad to the main body part 311. The sampling terminal 32 is welded to the bonding pad. In this way, the sampling terminal 32 can be electrically connected to the main body part 311 so as to allow the electrical data collected by the sampling terminal 32 to be transmitted to the main body part 311.

According to some embodiments of the present disclosure, the board body 31 is provided with an edge 34. The groove portion 33 comprises a first groove 331 and a second groove 332. The first groove 331 includes a first groove segment 3311, a second groove segment 3312, and a third groove segment 3313 which are sequentially connected. One end of the first groove segment 3311 penetrates through the edge 34, and the second groove segment 3312 extends along an extension direction of the edge 34. The first groove segment 3311 and the third groove segment 3313 are on the same side of the second groove segment 3312. One end of the second groove 332 penetrates through the edge 34, and the deformable part 312 is formed in a region of the board body 31 between the second groove 332 and the third groove segment 3313.

The edge 34 is a side portion of the board body 31. The second groove segment 3312 is a groove in the board body 31 in the same extension direction as the edge 34. The first groove segment 3311 penetrates through the edge 34 and extends to the groove of the second groove segment 3312. The third groove segment 3313 is a groove approaching from the second groove segment 3312 toward the edge 34. The first groove segment 3311, the second groove segment 3312, and the third groove segment 3313 are sequentially in communication.

The second groove 332 is another groove penetrating through the edge 34. The second groove 332 is partitioned from the first groove 331 so as to form the deformable part 312 between the second groove 332 and the third groove segment 3313.

By arranging the first groove segment 3311 and the second groove segment 3312 on the board body 31, the board body 31 is partitioned into a main body part 311 and a connecting part 313. The third groove segment 3313 and the second groove 332, provided on the board body 31, weaken the strength of the portion between the connecting part 313 and the main body part 311, thus making it easy to deform so that a deformable part 312 is partitioned between the main body part 311 and the connecting part 313. In this way, when external force is applied to the sampling terminal 32, the external force is transmitted to the connecting part 313, and the connecting part 313 pulls the deformable part 312 so as to cause the deformable part 312 to undergo deformation. Therefore, it allows the sampling terminal 32 to move relative to the main body part 311. This prevents damage to the sampling terminal 32 or the board body 31 when the sampling terminal 32 is subjected to external force and cannot move relative to the board body 31.

According to some embodiments of the present disclosure, the second groove 332 extends from the edge 34 towards the direction close to the second groove segment 3312, and the third groove segment 3313 extends from the second groove segment 3312 towards the direction close to the edge 34. In the extension direction of the edge 34, the second groove 332 is located between the third groove segment 3313 and the first groove segment 3311.

"The second groove 332 extends from the edge 34 towards the direction close to the second groove segment 3312" can mean that the second groove 332 extends from the edge 34 in a direction perpendicular to the extension direction of the edge 34 towards the second groove segment 3312. It can also mean that the second groove 332 extends from the edge 34 in a direction forming an acute angle with the extension direction of the edge 34 towards the second groove segment 3312. Additionally, it can also mean that the second groove 332 extends along a curved trajectory from the edge 34 towards the second groove segment 3312.

"The third groove segment 3313 extends from the second groove segment 3312 towards the direction close to the edge 34" can mean that the third groove segment 3313 extends from the second groove segment 3312 in a direction perpendicular to the extension direction of the edge 34 towards the edge 34. It can also mean that the third groove segment 3313 extends from the second groove segment 3312 in a direction forming an acute angle with the extension direction of the edge 34 towards the edge 34. Additionally, it can also mean that the third groove segment 3313 extends along a curved trajectory from the second groove segment 3312 towards the edge 34.

The second groove 332 extends from the edge 34 towards the second groove segment 3312. In comparison to the third groove segment 3313, the second groove 332 is closer to the connecting part 313. When welding the sampling terminal 32 to the connecting part 313, the second groove 332 can reduce the transfer of heat to the main body part 311, thereby minimizing the impact of heat on the main body part 311 during welding.

According to some other embodiments of the present disclosure, in the extension direction of the edge 34, the third groove segment 3313 is located between the second groove 332 and the first groove segment 3311.

According to some embodiments of the present disclosure, both the third groove segment 3313 and the second groove 332 are open-ended grooves with an arc shape. Configuring the third groove segment 3313 and the second groove 332 as open-ended grooves in an arc shape enhances the tear resistance performance of the deformable part 312.

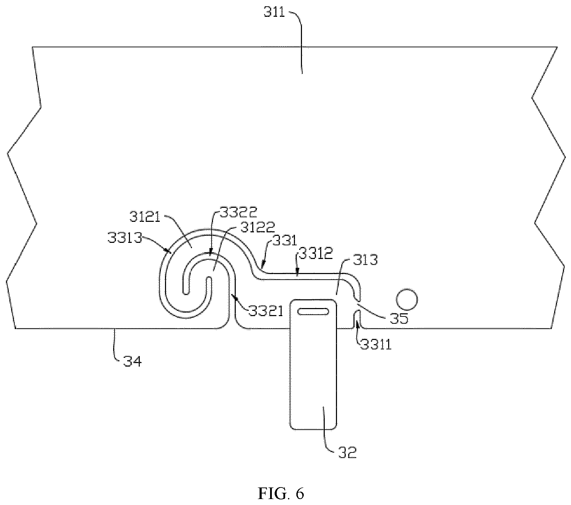

Referring to FIGS. 6, FIG. 6 is a schematic diagram of a structure of a flexible circuit board component 30 provided by some other embodiments of the present disclosure. The second groove 332 includes a fourth groove segment 3321 and a fifth groove segment 3322 which are sequentially connected. One end of the fourth groove segment 3321 penetrates through the edge 34, and the fifth groove segment 3322 is arranged in a mutually coiled manner with the third groove segment 3313 to make the deformable part 312 extend along a spiral trajectory.

The fourth groove segment 3321 is the portion of the second groove 332 that penetrates through the edge 34. The fifth groove segment 3322 is the portion of the second groove 332 that is in communication with the fourth groove segment 3321. The fifth groove segment 3322 and the third groove segment 3313 can be coiled mutually so that the deformable part 312 presents a spiral shape.

By mutually coiling the third groove segment 3313 and the fifth groove segment 3322, the deformable part 312 extends along a spiral trajectory. The deformable part 312 extending along the spiral trajectory is more prone to deformation, and the deformation range is relatively large.

According to some embodiments of the present disclosure, the amount of deformation of the deformable part 312 allows the connecting part 313 to be displaced beyond the first groove segment 3311 in an extension direction along the edge 34.

"The amount of deformation of the deformable part 312 allows the connecting part 313 to be displaced beyond the first groove segment 3311 in an extension direction along the edge 34" means that when the deformation of the deformable part 312 reaches its limit or maximum, the connecting part 313 displaces beyond the first groove segment 3311 in the extension direction of the edge 34.

By the amount of deformation of the deformable part 312, the connecting part 313 is allowed to displace beyond the first groove segment 3311 in the extension direction of the edge 34. Therefore, a sufficient relative displacement is provided for the connecting part 313 relative to the main body part 311, which adapt the amount of the expansion displacement of the battery cell 20.

According to some embodiments of the present disclosure, the board body 31 includes a weak part 35, and the weak part 35 is connected to the opposite two groove walls of the first groove segment 3311.

The weak part 35 is connected to the opposite two groove walls of the first groove segment 3311. In other words, the weak part 35 is connected to the connecting part 313 and the main body part 311. The weak part 35 has lower strength, and the weak part 35 is prone to fracture when subjected to external force. This allows the connecting part 313 to move relative to the main body part 311 when the deformable part 312 undergoes deformation. Consequently, it enables the sampling terminal 32 to move relative to the main body part 311 so as to adapt the expansion displacement of the battery cell 20.

By using the weak part 35, the opposite two groove walls of the first groove segment 3311 are connected so as to facilitate the positioning of the connecting part 313 and the sampling terminal 32 during assembly, thereby improving the accuracy of the connection between the connecting part 313 and the sampling terminal 32.

Referring to FIG. 6 and according to some embodiments of the present disclosure, the deformable part 312 includes a first winding segment 3121 and a second winding segment 3122. One end of the first winding segment 3121 is connected to one end of the second winding segment 3122. The first winding segment 3121 and the second winding segment 3122 wind in the same direction with their connection position as the winding center. The other end of the first winding segment 3121 is connected to the connecting part 313, and the other end of the second winding segment 3122 is connected to the main body part 311.

Both the first winding segment 3121 and the second winding segment 3122 extend along a spiral trajectory. The two ends of the first winding segment 3121 are respectively connected to the second winding segment 3122 and the connecting part 313. The two ends of the second winding segment 3122 are respectively connected to the first winding segment 3121 and the main body part 311.

The deformable part 312 forms a winding structure by making the first winding segment 3121 and the second winding segment 3122 wind in the same direction. The winding structure is more prone to deformation, and the deformation range is relatively large, thereby allowing it to adapt the amount of the expansion displacement of the battery cell 20.

According to some embodiments of the present disclosure, the deformable part 312 extends along an S-shaped trajectory.

"The deformable part 312 extends along an S-shaped trajectory" can also be understood to mean that the deformable part 312 is S-shaped.

The deformable part 312 that extends along an S-shaped trajectory is more prone to deformation and maintains good strength.

According to the invention, the deformable part 312 extends along a spiral trajectory.

"The deformable part 312 extends along a spiral trajectory" can also be understood to mean that the deformable part 312 is spiral-shaped.

The deformable part 312 extending along the spiral trajectory is more prone to deformation, and the deformation range is relatively large.

According to some embodiments of the present disclosure, the board body 31 is provided with multiple groove portions 33. The multiple groove portions 33 partition the board body 31 into the main body part 311, multiple connecting parts 313, and multiple deformable parts 312. The connecting part 313 is in one-to-one correspondence with the deformable part 312. The deformable part 312 is connected to the main body part 311 and the connecting part 313. By arranging multiple deformable parts 312 and multiple connecting parts 313, it facilitates the arrangement of multiple sampling terminals 32 for connecting to multiple battery cells 20.

According to some embodiments of the present disclosure, with the middle position of the main body part 311 as the reference, the deformation directions of multiple deformable parts 312 located on either side of the middle position all point towards the middle position.

According to some embodiments of the present disclosure, a battery 100 is further provided. The battery 100 includes multiple battery cells 20, a busbar component 40, and the aforementioned flexible circuit board component 30. The busbar component 40 is configured to connect the multiple battery cells 20 in series or in parallel, and the sampling terminal 32 is connected to the busbar component 40.

The battery cell 20 refers to the smallest unit comprising the battery 100. In the battery 100, multiple battery cells 20 can be provided. The multiple battery cells 20 can be connected in series, parallel, or hybrid. Hybrid connection refers to having both series and parallel connections among multiple battery cells 20. The multiple battery cells 20 can be directly connected in series, parallel, or hybrid, and then the whole comprising the multiple battery cells 20 is housed in the box 10. Of course, the battery 100 can also be in the form that, the multiple battery cells 20 are first connected in series, parallel, or hybrid to form battery modules, and then the multiple battery modules are connected in series, parallel, or hybrid to be formed as a whole, which is housed in the box 10. Each battery cell 20 can be a secondary battery cell or a primary battery cell. It can also be a lithium-sulfur battery cell, sodium-ion battery cell, magnesium-ion battery cell, or other types, but is not limited to these. The battery cell 20 can have various shapes such as cylindrical, flat, rectangular, or other shapes.

The busbar component 40 is configured for achieving an electrical connection between the multiple battery cells 20. The flexible circuit board component 30 is electrically connected to the busbar component 40, and the busbar component 40 is electrically connected to the battery cell 20. In other words, the flexible circuit board component 30 is electrically connected to the battery cell 20 through the busbar component 40, or the busbar component 40 is electrically connected to both the flexible circuit board component 30 and the battery cell 20.

By providing the flexible circuit board component 30 of the battery 100 described above, after a certain period of the use of the battery 100, the battery cell 20 undergoes expansion, and the sampling terminal 32 can move along with the expansion of the battery cell 20. Therefore, this prevents the separation of the flexible circuit board component 30 from the battery cell 20 so as to allow continuous collection of voltage and temperature data from the battery cell 20, which enables the battery 100 to have a long life and stability.

According to some embodiments of the present disclosure, an electric device is further provided, wherein the electric device comprises the battery 100 as described above and the battery 100 is configured to provide electrical energy.

According to some embodiments of the present disclosure, with reference to FIG. 4 and FIG. 5,
the flexible circuit board component 30 comprises a board body 31 and a sampling terminal 32, wherein the sampling terminal 32 is configured to collect the electrical data of the target component. The board body 31 is provided thereon with a groove portion 33, wherein the groove portion 33 penetrates the board body 31 along a thickness direction of the board body 31 so as to partition the board body 31 into a main body part 311, a connecting part 313, and a deformable part 312. The connecting part 313 is configured to connect the sampling terminal 32, and the deformable part 312 is connected to the main body part 311 and the connecting part 313. The deformable part 312 is configured to undergo deformation so as to allow the connecting part 313 to be able to displace relative to the main body part 311. The board body 31 is provided with an edge 34. The groove portion 33 comprises a first groove 331 and a second groove 332. The first groove 331 includes a first groove segment 3311, a second groove segment 3312, and a third groove segment 3313 which are sequentially connected. One end of the first groove segment 3311 penetrates through the edge 34, and the second groove segment 3312 extends along an extension direction of the edge 34. The first groove segment 3311 and the third groove segment 3313 are on the same side of the second groove segment 3312. One end of the second groove 332 penetrates through the edge 34, and the deformable part 312 is formed in a region of the board body 31 between the second groove 332 and the third groove segment 3313. The second groove 332 extends from the edge 34 towards the direction close to the second groove segment 3312, and the third groove segment 3313 extends from the second groove segment 3312 towards the direction close to the edge 34. In the extension direction of the edge 34, the second groove 332 is located between the third groove segment 3313 and the first groove segment 3311.

The flexible circuit board component 30 is provided with a groove portion 33 penetrating the board body 31 along the thickness direction of the board body 31, and thus, the deformable part 312 and the connecting part 313 are formed on the board body 31, wherein the connecting part 313 is connected to the sampling terminal 32. When external force is applied to the sampling terminal 32, the deformable part 312 can undergo deformation, thus allowing the sampling terminal 32 to move relative to the main body part 311. This prevents damage to the sampling terminal 32 or the board body 31 when the sampling terminal 32 is subjected to external force and cannot move relative to the board body 31. After a certain period of the use of the battery 100, the battery cell 20 may experience expansion and displacement, exerting external force on the sampling terminals 32. In the flexible circuit board component 30 provided by the embodiments of the present disclosure, the sampling terminal 32 can move along with the expansion of the battery cells 20. Therefore, this prevents the separation of the flexible circuit board component 30 from the battery cell 20 so as to allow continuous collection of voltage and temperature data from the battery cell 20. The main body part 311, connecting part 313, and deformable part 312 of the flexible circuit board component 30 can be formed in a single step through the stamping of the board body 31. This manufacturing process is simple, convenient, and efficient. By arranging the first groove segment 3311 and the second groove segment 3312 on the board body 31, the board body 31 is partitioned into a main body part 311 and a connecting part 313. The third groove segment 3313 and the second groove 332, provided on the board body 31, weaken the strength of the portion between the connecting part 313 and the main body part 311, thus making it easy to deform so that a deformable part 312 is partitioned between the main body part 311 and the connecting part 313. **In** this way, when external force is applied to the sampling terminal 32, the external force is transmitted to the connecting part 313, and the connecting part 313 pulls the deformable part 312 so as to cause the deformable part 312 to undergo deformation. Therefore, it allows the sampling terminal 32 to move relative to the main body part 311. This prevents damage to the sampling terminal 32 or the board body 31 when the sampling terminal 32 is subjected to external force and cannot move relative to the board body 31. The second groove 332 extends from the edge 34 towards the second groove segment 3312. In comparison to the third groove segment 3313, the second groove 332 is closer to the connecting part 313. When welding the sampling terminal 32 to the connecting part 313, the second groove 332 can reduce the transfer of heat to the main body part 311, thereby minimizing the impact of heat on the main body part 311 during welding.

According to some embodiments of the present disclosure, with reference to FIG. 6,
the second groove 332 includes a fourth groove segment 3321 and a fifth groove segment 3322 which are sequentially connected. One end of the fourth groove segment 3321 penetrates through the edge 34, and the fifth groove segment 3322 is arranged in a mutually coiled manner with the third groove segment 3313 to make the deformable part 312 extend along a spiral trajectory. By mutually coiling the third groove segment 3313 and the fifth groove segment 3322, the deformable part 312 extends along a spiral trajectory. The deformable part 312 extending along the spiral trajectory is more prone to deformation, and the deformation range is relatively large. The board body 31 includes a weak part 35, and the weak part 35 is connected to the opposite two groove walls of the first groove segment 3311. By using the weak part 35, the opposite two groove walls of the first groove segment 3311 are connected so as to facilitate the positioning of the connecting part 313 and the sampling terminal 32 during assembly, thereby improving the accuracy of the connection between the connecting part 313 and the sampling terminal 32.

The above is only a preferred embodiment of the present disclosure, which is not intended to limit, and the present disclosure may have various changes and variations for those skilled in the art. The scope of protection is defined by the appended claims.

## Claims

1. A flexible circuit board component (30), comprising
a board body (31); and
a sampling terminal (32), configured to collect electrical data of a target component, wherein
the board body (31) is provided thereon with a groove portion (33), wherein the groove portion (33) penetrates the board body (31) along a thickness direction of the board body (31) so as to partition the board body (31) into a main body part (311), a connecting part (313), and a deformable part (312); the connecting part (313) is configured to connect to the sampling terminal (32), and the deformable part (312) is connected to the main body part (311) and the connecting part (313); and the deformable part (312) is configured to undergo deformation so as to allow the connecting part (313) to displace relative to the main body part (311), **characterized in that** the deformable part (312) extends along a spiral trajectory.

2. The flexible circuit board component (30) according to claim 1, wherein the board body (31) is provided with an edge (34); and
the groove portion (33) comprises
a first groove (331), comprising a first groove segment (3311), a second groove segment (3312), and a third groove segment (3313) which are sequentially connected; one end of the first groove segment (3311) penetrates through the edge (34), and the second groove segment (3312) extends along an extension direction of the edge (34); the first groove segment (3311) and the third groove segment (3313) are on the same side of the second groove segment (3312), wherein the first groove segment (3311) and the third groove segment (3313) extend between the second groove segment (3312) and the edge (34); and
a second groove (332), wherein one end of the second groove (332) penetrates through the edge (34), and the deformable part (312) is formed in a region of the board body (31) between the second groove (332) and the third groove segment (3313).

3. The flexible circuit board component (30) according to claim 2, wherein the second groove (332) extends from the edge (34) toward a direction close to the second groove segment (3312), and the third groove segment (3313) extends from the second groove segment (3312) toward a direction close to the edge (34); and in the extension direction of the edge (34), the second groove (332) is arranged between the third groove segment (3313) and the first groove segment (3311).

4. The flexible circuit board component (30) according to claim 2, wherein the second groove (332) comprises a fourth groove segment (3321) and a fifth groove segment (3322) which are sequentially connected; one end of the fourth groove segment (3321) penetrates through the edge (34), and the fifth groove segment (3322) is arranged in a mutually coiled manner with the third groove segment (3313) to make the deformable part (312) extend along a spiral trajectory.

5. The flexible circuit board component (30) according to any one of claims 2 to 4, wherein an amount of deformation of the deformable part (312) allows the connecting part (313) to be displaced beyond the first groove segment (3311) in an extension direction along the edge (34).

6. The flexible circuit board component (30) according to any one of claims 2 to 5, wherein the board body (31) comprises a weak part (35), the weak part (35) is connected to the opposite two groove walls of the first groove segment (3311), and the weak part (35) is prone to fracture when subjected to external force, to allow the connecting part (313) to move relative to the main body part (311) when the deformable part (312) undergoes deformation.

7. The flexible circuit board component (30) according to any one of claims 1 to 6, wherein the deformable part (312) comprises a first winding segment (3121) and a second winding segment (3122), wherein one end of the first winding segment (3121) is connected to one end of the second winding segment (3122); the first winding segment (3121) and the second winding segment (3122) wind in the same direction with their connection position as a winding center; and
the other end of the first winding segment (3121) is connected to the connecting part (313), and the other end of the second winding segment (3122) is connected to the main body part (311).

8. The flexible circuit board component (30) according to any one of claims 1 to 3, wherein the deformable part (312) extends along an S-shaped trajectory.

9. A battery (100), comprising
multiple battery cells (20);
a busbar component (40), configured to connect the multiple battery cells (20) in series or in parallel; and
the flexible circuit board component (30) according to any one of claims 1 to 8, wherein the sampling terminal (32) is connected to the busbar component (40).

10. An electric device, comprising the battery (100) according to claim 9, wherein the battery (100) is configured to provide electrical energy.

## Patentansprüche

1. Flexible Leiterplattenkomponente (30), umfassend:
einen Platinenkörper (31); und
einen Abtastanschluss (32), der dazu ausgelegt ist, elektrische Daten einer Zielkomponente zu erfassen, wobei
der Platinenkörper (31) darauf mit einem Nutenabschnitt (33) versehen ist, wobei der Nutenabschnitt (33) den Platinenkörper (31) entlang einer Dickenrichtung des Platinenkörpers (31) durchdringt, sodass der Platinenkörper (31) in einen Hauptkörperteil (311), einen Verbindungsteil (313) und einen verformbaren Teil (312) aufgeteilt wird; wobei der Verbindungsteil (313) dazu ausgelegt ist, mit dem Abtastanschluss (32) verbunden zu sein, und der verformbare Teil (312) mit dem Hauptkörperteil (311) und dem Verbindungsteil (313) verbunden ist; und der verformbare Teil (312) dazu ausgelegt ist, eine Verformung zu erfahren, um dem Verbindungsteil (313) zu ermöglichen, relativ zu dem Hauptkörperteil (311) verlagert zu werden, **dadurch gekennzeichnet, dass** sich der verformbare Teil (312) entlang einer spiralförmigen Trajektorie erstreckt.

2. Flexible Leiterplattenkomponente (30) nach Anspruch 1, wobei der Platinenkörper (31) mit einem Rand (34) versehen ist; und
der Nutenabschnitt (33) umfasst:
eine erste Nut (331), die ein erstes Nutensegment (3311), ein zweites Nutensegment (3312) und ein drittes Nutensegment (3313) umfasst, die sequenziell verbunden sind; wobei ein Ende des ersten Nutensegments (3311) den Rand (34) durchdringt und sich das zweite Nutensegment (3312) entlang einer Verlängerungsrichtung des Randes (34) erstreckt; wobei sich das erste Nutensegment (3311) und das dritte Nutensegment (3313) auf derselben Seite des zweiten Nutensegments (3312) befinden, wobei sich das erste Nutensegment (3311) und das dritte Nutensegment (3313) zwischen dem zweiten Nutensegment (3312) und dem Rand (34) erstrecken; und
eine zweite Nut (332), wobei ein Ende der zweiten Nut (332) den Rand (34) durchdringt, und der verformbare Teil (312) in einem Bereich des Platinenkörpers (31) zwischen der zweiten Nut (332) und dem dritten Nutensegment (3313) ausgebildet ist.

3. Flexible Leiterplattenkomponente (30) nach Anspruch 2, wobei sich die zweite Nut (332) vom Rand (34) zu einer Richtung nahe des zweiten Nutensegments (3312) erstreckt und sich das dritte Nutensegment (3313) vom zweiten Nutensegment (3312) zu einer Richtung nahe dem Rand (34) erstreckt; und in die Verlängerungsrichtung des Randes (34), die zweite Nut (332) zwischen dem dritten Nutensegment (3313) und dem ersten Nutensegment (3311) angeordnet ist.

4. Flexible Leiterplattenkomponente (30) nach Anspruch 2, wobei die zweite Nut (332) ein viertes Nutensegment (3321) und ein fünftes Nutensegment (3322) umfasst, die sequenziell verbunden sind; wobei ein Ende des vierten Nutensegments (3321) den Rand (34) durchdringt und das fünfte Nutensegment (3322) auf eine ineinander verschlungene Art und Weise mit dem dritten Nutensegment (3313) angeordnet ist, um zu veranlassen, dass sich der verformbare Teil (312) entlang einer spiralförmigen Trajektorie erstreckt.

5. Flexible Leiterplattenkomponente (30) nach einem der Ansprüche 2 bis 4, wobei ein Ausmaß an Verformung des verformbaren Teils (312) ermöglicht, dass der Verbindungsteil (313) über das erste Nutensegment (3311) hinaus in eine Verlängerungsrichtung entlang des Randes (34) verlagert wird.

6. Flexible Leiterplattenkomponente (30) nach einem der Ansprüche 2 bis 5, wobei der Platinenkörper (31) einen schwachen Teil (35) umfasst, wobei der schwache Teil (35) mit den gegenüberliegenden zwei Nutenwänden des ersten Nutensegments (3311) verbunden ist, und der schwache Teil (35) dazu neigt, zu brechen, wenn er einer externen Kraft ausgesetzt wird, um zu ermöglichen, dass sich der Verbindungsteil (313) relativ zu dem Hauptkörperteil (311) bewegt, wenn der verformbare Teil (312) eine Verformung erfährt.

7. Flexible Leiterplattenkomponente (30) nach einem der Ansprüche 1 bis 6, wobei der verformbare Teil (312) ein erstes Windungssegment (3121) und ein zweites Windungssegment (3122) umfasst, wobei ein Ende des ersten Windungssegments (3121) mit einem Ende des zweiten Windungssegments (3122) verbunden ist; wobei das erste Windungssegment (3121) und das zweite Windungssegment (3122) in dieselbe Richtung mit ihrer Verbindungsposition als eine Windungsmitte gewickelt sind; und
das andere Ende des ersten Windungssegments (3121) mit dem Verbindungsteil (313) verbunden ist, und das andere Ende des zweiten Windungssegments (3122) mit dem Hauptkörperteil (311) verbunden ist.

8. Flexible Leiterplattenkomponente (30) nach einem der Ansprüche 1 bis 3, wobei sich der verformbare Teil (312) entlang einer S-förmigen Trajektorie erstreckt.

9. Batterie (100), umfassend:
mehrere Batteriezellen (20);
eine Sammelschienenkomponente (40), die dazu ausgelegt ist, mit den mehreren Batteriezellen (20) in Reihe oder parallel verbunden zu sein; und
die flexible Leiterplattenkomponente (30) nach einem der Ansprüche 1 bis 8, wobei der Abtastanschluss (32) mit der Sammelschienenkomponente (40) verbunden ist.

10. Elektrische Vorrichtung, umfassend die Batterie (100) nach Anspruch 9, wobei die Batterie (100) dazu ausgelegt ist, elektrische Energie bereitzustellen.

## Revendications

1. Composant (30) de carte de circuit imprimé flexible, comprenant :
un corps (31) de carte ; et
une borne d'échantillonnage (32), configurée pour collecter des données électriques d'un composant cible,
le corps (31) de carte étant pourvu, à sa surface, d'une portion à rainures (33), la portion à rainures (33) traversant le corps (31) de carte selon une direction d'épaisseur du corps (31) de carte de manière à séparer le corps (31) de carte en une partie principale (311) de corps, une partie de connexion (313), et une partie déformable (312) ; la partie de connexion (313) étant configurée pour se connecter à la borne d'échantillonnage (32), et la partie déformable (312) étant connectée à la partie principale (311) de corps et à la partie de connexion (313) ; et la partie déformable (312) étant configurée pour subir une déformation de manière à permettre le déplacement de la partie de connexion (313) par rapport à la partie principale (311) de corps,
**caractérisé en ce que** la partie déformable (312) s'étend selon une trajectoire en spirale.

2. Composant (30) de carte de circuit imprimé flexible selon la revendication 1, dans lequel le corps (31) de carte est pourvu d'un bord (34) ; et
la portion à rainures (33) comprend
une première rainure (331), comprenant un premier segment de rainure (3311), un deuxième segment de rainure (3312), et un troisième segment de rainure (3313) connectés séquentiellement ; une extrémité du premier segment de rainure (3311) traversant le bord (34), et le deuxième segment de rainure (3312) s'étendant selon une direction d'extension du bord (34) ; le premier segment de rainure (3311) et le troisième segment de rainure (3313) étant situés sur le même côté du deuxième segment de rainure (3312), le premier segment de rainure (3311) et le troisième segment de rainure (3313) s'étendant entre le deuxième segment de rainure (3312) et le bord (34) ; et
une deuxième rainure (332), une extrémité de ladite deuxième rainure (332) traversant le bord (34), et la partie déformable (312) étant formée dans une région du corps (31) de carte entre la deuxième rainure (332) et le troisième segment de rainure (3313).

3. Composant (30) de carte de circuit imprimé flexible selon la revendication 2, dans lequel la deuxième rainure (332) s'étend depuis le bord (34) dans une direction se rapprochant du deuxième segment de rainure (3312), et le troisième segment de rainure (3313) s'étend depuis le deuxième segment de rainure (3312) dans une direction se rapprochant du bord (34) ; et, dans la direction d'extension du bord (34), la deuxième rainure (332) est agencée entre le troisième segment de rainure (3313) et le premier segment de rainure (3311).

4. Composant (30) de carte de circuit imprimé flexible selon la revendication 2, dans lequel la deuxième rainure (332) comprend un quatrième segment de rainure (3321) et un cinquième segment de rainure (3322) connectés séquentiellement ; une extrémité du quatrième segment de rainure (3321) traverse le bord (34), et le cinquième segment de rainure (3322) est agencé de manière enroulée l'un par rapport l'autre avec le troisième segment de rainure (3313) afin de faire s'étendre la partie déformable (312) selon une trajectoire en spirale.

5. Composant (30) de carte de circuit imprimé flexible selon l'une quelconque des revendications 2 à 4, dans lequel une quantité de déformation de la partie déformable (312) permet le déplacement de la partie de connexion (313) au-delà du premier segment de rainure (3311) dans une direction d'extension le long du bord (34).

6. Composant (30) de carte de circuit imprimé flexible selon l'une quelconque des revendications 2 à 5, dans lequel le corps (31) de carte comprend une partie affaiblie (35), la partie affaiblie (35) est connectée aux deux parois de rainure opposées du premier segment de rainure (3311), et la partie affaiblie (35) est apte à se rompre sous l'effet d'une force externe, pour permettre le déplacement de la partie de connexion (313) par rapport à la partie principale (311) de corps lorsque la partie déformable (312) subit une déformation.

7. Composant (30) de carte de circuit imprimé flexible selon l'une quelconque des revendications 1 à 6, dans lequel la partie déformable (312) comprend un premier segment d'enroulement (3121) et un deuxième segment d'enroulement (3122), une extrémité du premier segment d'enroulement (3121) étant connectée à une extrémité du deuxième segment d'enroulement (3122) ; le premier segment d'enroulement (3121) et le deuxième segment d'enroulement (3122) s'enroulant dans le même sens avec, pour centre d'enroulement, leur position de connexion ; et
l'autre extrémité du premier segment d'enroulement (3121) étant connectée à la partie de connexion (313), et l'autre extrémité du deuxième segment d'enroulement (3122) étant connectée à la partie principale (311) de corps.

8. Composant (30) de carte de circuit imprimé flexible selon l'une quelconque des revendications 1 à 3, dans lequel la partie déformable (312) s'étend selon une trajectoire en S.

9. Batterie (100), comprenant :
de multiples cellules (20) de batterie ;
un composant de barre omnibus (40), configuré pour connecter les multiples cellules (20) de batterie en série ou en parallèle ; et
le composant (30) de carte de circuit imprimé flexible selon l'une quelconque des revendications 1 à 8, la borne d'échantillonnage (32) étant connectée au composant de barre omnibus (40).

10. Dispositif électrique, comprenant la batterie (100) selon la revendication 9, la batterie (100) étant configurée pour fournir de l'énergie électrique.
